(19) Europäisches Patentamt
European Patent Office
Office européen des brevets

(11) EP 2 600 693 A1

(12) **EUROPEAN PATENT APPLICATION**
published in accordance with Art. 153(4) EPC

(43) Date of publication:
**05.06.2013 Bulletin 2013/23**

(21) Application number: **11812402.3**

(22) Date of filing: **22.07.2011**

(51) Int Cl.:
***H05B 33/02*** *(2006.01)* ***C03C 3/19*** *(2006.01)*
***C03C 3/21*** *(2006.01)* ***H01L 51/50*** *(2006.01)*

(86) International application number:
**PCT/JP2011/066726**

(87) International publication number:
**WO 2012/014812 (02.02.2012 Gazette 2012/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.07.2010 JP 2010167093**

(71) Applicant: **Asahi Glass Company, Limited**
**Tokyo 100-8405 (JP)**

(72) Inventors:
- **WADA, Naoya**
  **Tokyo 100-8405 (JP)**
- **NAKAMURA, Nobuhiro**
  **Tokyo 100-8405 (JP)**
- **ISHIBASHI, Nao**
  **Tokyo 100-8405 (JP)**
- **TANIDA, Masamichi**
  **Tokyo 100-8405 (JP)**

(74) Representative: **Müller-Boré & Partner**
**Patentanwälte**
**Grafinger Straße 2**
**81671 München (DE)**

(54) **GLASS FOR SCATTERING LAYER OF ORGANIC LED ELEMENT, AND ORGANIC LED ELEMENT**

(57) A glass used for a scattering layer of an organic LED element, and an organic LED element using the scattering layer are provided. The present invention relates to an organic LED element including a transparent substrate, a first electrode, an organic layer, and a second electrode in this order, which includes a scattering layer including, in terms of mol% on the basis of oxides thereof: 15 to 30 % of $P_2O_5$; 5 to 30 % of $Bi_2O_3$; 5 to 27 % of $Nb_2O_5$; and 4 to 40 % of ZnO, wherein a total content of alkali metal oxides consisting of $Li_2O$, $Na_2O$, and $K_2O$ is 5 mass% or less.

FIG. 1

150
140
130
121
120
122
110

EP 2 600 693 A1

## Description

### Technical Field

The present invention relates to a glass and, particularly to a glass used for a scattering layer of an organic LED element, and an organic LED element using the glass.

### Background Art

An organic LED element has an organic layer. There is a bottom emission type for the organic LED element that extracts light, which is generated in the organic layer, from a transparent substrate.

The current situation of the organic LED element is that the quantity of light extracted from the organic LED element to the outside is less than 20 % of the emitted light.

In regard to this, there are documents which disclose that a scattering layer composed of a glass is placed in the organic LED element to enhance the efficiency of light extraction (Patent Documents 1 and 3). There is a document which discloses the composition as an optical glass, although it is not the glass composition for a scattering layer of an organic LED element (Patent Document 2).

Further, environmental pollution involving in melting of a glass containing a lead oxide has recently become a critical issue. Therefore, the glass is required to be free of the lead oxide.

### Background Art Documents

#### Patent Documents

Patent Document 1: JP-A-2004-513483 Patent Document 2: JP-A-2007-119343 Patent Document 3: WO 2009/017035

### Summary of the Invention

#### Problems that the Invention is to Solve

However, the content of a glass composition is not disclosed or suggested in the Patent Document 1, bringing about a difficulty in the implementation thereof. The glass disclosed in the Patent Document 2 contains, as an essential ingredient, a large quantity of $GeO_2$ of which the raw material is expensive, causing a problem that the cost for the raw material is extremely increased. Further, the Patent Document 2 does not specifically describe that the glass is used as a scattering layer in an organic LED element, and the efficiency of light extraction is enhanced thereby. The Patent Document 3 discloses one characteristic value in the paragraph 0164, but the composition of only one glass presented in Table 3 does not contain ZnO. This obscures the range of characteristics disclosed in the Patent Document 3.

#### Means for Solving the Problems

The present invention provides the following glass for scattering of an organic LED element, and organic LED element.

(1) A glass for a scattering layer of an organic LED element, comprising, in terms of mol% on the basis of oxides thereof:

15 to 30 % of $P_2O_5$;
5 to 30 % of $Bi_2O_3$;
5 to 27 % of $Nb_2O_5$; and
4 to 40 % of ZnO,
wherein a total content of alkali metal oxides consisting of $Li_2O$, $Na_2O$, and $K_2O$ is 5 mass% or less.

(2) The glass for a scattering layer of an organic LED element according to (1), wherein the total content of the alkali metal oxides is 2 mass% or less.

(3) The glass for a scattering layer of an organic LED element according to (1) or (2), which does not substantially contain the alkali metal oxides.

(4) The glass for a scattering layer of an organic LED element according to any one of (1) to (3), which does not

substantially contain $TiO_2$.

(5) The glass for a scattering layer of an organic LED element according to any one of (1) to (4), which contains the ZnO in an amount of 21 mol% or more.

(6) The glass for a scattering layer of an organic LED element according to any one of (1) to (5), which does not substantially contain a lead oxide.

(7) An organic LED element, comprising a transparent substrate, a first electrode, an organic layer, and a second electrode in this order,

which comprises a scattering layer comprising, in terms of mol% on the basis of oxides thereof: 15 to 30 % of $P_2O_5$; 5 to 30 % of $Bi_2O_3$; 5 to 27 % of $Nb_2O_5$; 4 to 40 % of ZnO, wherein a total content of alkali metal oxides consisting of $Li_2O$, $Na_2O$, and $K_2O$ is 5 mass% or less.

(8) The organic LED element according to (7), wherein the scattering layer is placed on the transparent substrate.

(9) The organic LED element according to (7), wherein the scattering layer is placed on the organic layer.

(10) The organic LED element according to any one of (7) to (9), wherein the first and second electrodes are a transparent electrode.

(11) The organic LED element according to any one of (7) to (10), which is used for lighting.

Advantage of the Invention

According to the present invention, a glass for a scattering layer used in an organic LED element, or an organic LED element using the scattering layer can be provided. The use of the organic LED element can improve the efficiency of light extraction.

Brief Description of the Drawings

[FIG. 1] FIG. 1 is a cross-sectional view of a first organic LED element according to the present invention.

[FIG. 2] FIG. 2 is a cross-sectional view of a second organic LED element according to the present invention.

[FIG. 3] FIG. 3 is a graph showing the relationship between the refractive index of ITO and the refractive index of the glass for a scattering layer.

[FIG. 4] FIG. 4 is a top view showing the constitution of an element with a scattering layer.

[FIG. 5] FIG. 5 is a top view showing the constitution of an element without a scattering layer.

[FIG. 6] FIG. 6 is a graph showing the relationship between voltage and current.

[FIG. 7] FIG. 7 is a graph showing the relationship between luminous flux and current.

[FIG. 8] FIG. 8 is a conceptual diagram of a system for evaluating the angle dependency of emitted light.

[FIG. 9] FIG. 9 is a graph showing the relationship between luminance and angle.

[FIG. 10] FIG. 10 is a graph showing the relationship between chromaticity and angle.

Mode for Carrying Out the Invention

Embodiments of the present invention will be described in detail with reference to the drawings. In the figures, the corresponding reference numerals and signs are used to denote the corresponding part(s). It should be understood that the following embodiments are given as only one example, and any changes and modifications may be made within the scope of the embodiments herein without departing from the spirit thereof.

(Organic LED element)

Firstly, a description will be given as to an organic LED element of the present invention with reference to the drawings.

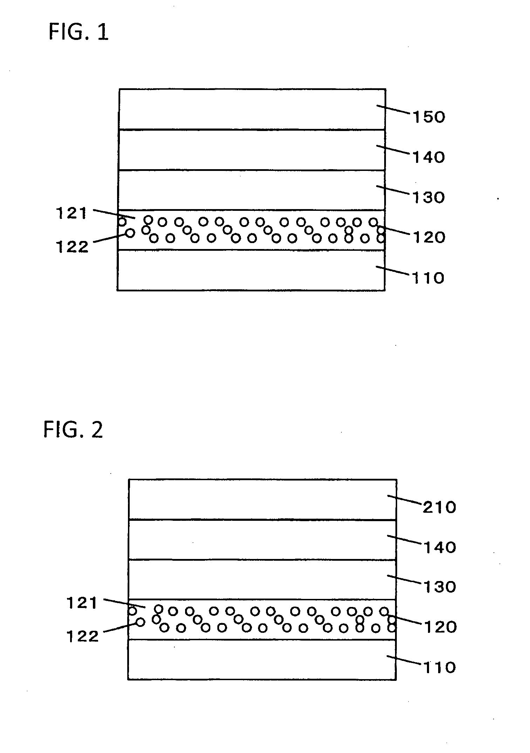

FIG. 1 is a cross-sectional view of a first organic LED element according to the present invention. The first organic LED element of the present invention is a bottom emission type organic LED element. The first organic LED element of the present invention includes a transparent substrate 110, a scattering layer 120 formed on the transparent substrate 110, a first electrode 130 formed on the scattering layer 120, an organic layer 140 formed on the first electrode 130, and a second electrode 150 formed on the organic layer 140. In the first organic LED element of the present invention, the first electrode 130 is a transparent electrode (anode), and the second electrode 150 is a reflective electrode (cathode). The first electrode 130 has transparency for transmitting the light emitted from the organic layer 140 to the scattering layer 120. On the other hand, the second electrode 150 has reflectivity for reflecting the light emitted from the organic layer 140 and turning it back to the organic layer 140.

FIG. 2 is a cross-sectional view of a second organic LED element according to the present invention. The second organic LED element of the present invention is a double-sided emission type organic LED element. The second organic LED element of the present invention includes a transparent substrate 110, a scattering layer 120 formed on the transparent substrate 110, a first electrode 130 formed on the scattering layer 120, an organic layer 140 formed on the first electrode 130, and a second electrode 210 formed on the organic layer 140. In the second organic LED element of the present invention, the first electrode 130 is a transparent electrode (anode), and the second electrode 210 is a transparent electrode (cathode). The first electrode 130 has transparency for transmitting the light emitted from the organic layer 140 to the scattering layer 120. On the other hand, the second electrode 210 has transparency for transmitting the light emitted from the organic layer 140 to the side opposite to the side facing the organic layer 140. The organic LED element is used for lighting applications that emits light from the front face and back face.

Hereinafter, a detailed description will be given as to each constitution of the first organic LED element. Needless to say, in the first and second LED elements, the parts having the same reference numerals have the same structure or the same function.

(Transparent substrate)

As a translucent substrate used in the formation of the transparent substrate 110, a material having high transmittance to visible light, such as a glass substrate, is mainly used. The specific examples of the material having high transmittance include a glass substrate and a plastic substrate. As the materials of the glass substrate, examples thereof include inorganic glass such as alkali glass, alkali-free glass, or quartz glass. A silica film or the like may be coated on the surface of the glass substrate in order to prevent diffusion of the glass component. As the materials of the plastic substrate, examples thereof include polyester, polycarbonate, polyether, polysulfone, polyether sulfone, polyvinyl alcohol, or fluorine-containing polymers such as polyvinylidene fluoride and polyvinyl fluoride. The plastic substrate may be constructed to have barrier properties in order to prevent penetration of water into the substrate. The thickness of the transparent substrate is preferably 0.1 to 2.0 mm for the glass. An extremely thin thickness leads to the decrease of the strength, so the thickness is preferably 0.5 to 1.0 mm.

(Scattering layer)

The scattering layer 120 is formed by forming a glass powder on a substrate by a method such as coating, and firing at a desired temperature. The scattering layer 120 includes a base material 121 having a first refractive index, and a plurality of scattering materials 122 having a second refractive index different from the refractive index of the base material 121 and being dispersed in the base material 121. The scattering layer, being made of a glass, can maintain smoothness of the surface as well as excellent scattering properties, and achieve light extraction with extremely high efficiency when used on a light-emitting side of a light emission device or the like.

Further, as the scattering layer, a glass (base material) having high light transmittance can be used. Inside the base material, a plurality of scattering materials (for example, bubbles, precipitated crystals, particles of a material different from the base material, and phase-separated glass) are formed. The term "particle" as used herein refers to a small solid material, such as fillers or ceramics. The term "bubble" as used herein means air or gaseous substance. The term "phase-separated glass" as used herein refers to a glass composed of at least two glass phases.

To achieve the improvement of the efficiency of light extraction, the refractive index of the base material is preferably equivalent to or higher than the refractive index of the first electrode. In the case where the refractive index of the base material is lower than that of the first electrode, there is a possibility that a loss in association with the total reflection occurs at the interface between the base material and the first electrode. The refractive index of the base material should be higher than that of the first electrode in at least a part (for example, red, blue, or green region) of the emission spectrum range of the organic layer. The refractive index thereof is preferably higher than that of the first electrode over the entire emission spectrum range (430 to 650 nm), more preferably over the entire wavelength range of visible light (360 to 830 nm). When the difference in refractive index between the base material and the first electrode is within 0.2, the refractive index of the first electrode may be higher than that of the base material.

In order to prevent a short circuit between electrodes of the organic LED element, the principal surface of the scattering layer is required to be smooth. It is therefore not desirable that the scattering materials are projecting from the principal surface of the scattering layer. To prevent the scattering materials from projecting from the principal surface of the scattering layer, it is preferred that the scattering materials do not exist within 0.2 μm from the principal surface of the scattering layer. The arithmetic average roughness (Ra) of the principal surface of the scattering layer as defined by JIS B0601-1994 is preferably 30 nm or less, more preferably 10 nm or less, particularly preferably 1 nm or less. The refractive indexes of both of the scattering material and the base material may be high, but the difference (Δn) in refractive index is preferably 0.05 or more in at least a part of the emission spectrum range of the light-emitting layer. In order to acquire sufficiently good scattering properties, the difference (Δn) in refractive index is preferably 0.05 or more over the entire emission spectrum range (430 to 650 nm) or the entire wavelength range of visible light (360 to 830 nm).

To acquire the maximum difference in refractive index, it is desirable to be the structure where a glass having a high refractive index is used as the base material and a gaseous substance, that is, bubbles, is used as the scattering material.

The color of the emitted light can be changed by providing a specific transmittance spectrum for the base material. As a colorant, conventional colorants, such as transition metal oxides, rare earth metal oxides, or metal colloids, can be used alone or in a mixture thereof.

Generally, white light emission is necessary for backlight or lighting applications. The known white lighting methods include a method of spatially differentiating the light in red, blue, or green colors (coding method), a method of laminating a light-emitting layer having different emission colors (lamination method), and a method of spatially separating the emitted light in blue and converting the color thereof by a color conversion material provided (color conversion method). The lamination method is commonly used for backlight or lighting applications which are only to require white chromaticity uniformly. The light-emitting layers laminated are provided to implement an additive color mixing to yield white. For example, a blue-green layer and an orange layer may be laminated, or a red layer, a blue layer and a green layer may be laminated. Particularly in the lighting applications, color reproducibility on the irradiated surface is important, and it is desirable to have light emission spectrum necessary to the visible light region. In the case of laminating a blue-green layer and an orange layer, the intensity of the green emission is low. Thus, color reproducibility deteriorates when illuminating an object having a lot of the green color. The lamination method has the merit that there is no need of spatially changing the color arrangement, but has two problems as follows. The first problem is that the thickness of the organic layer is thin, and thus, the extracted emission light is subjected to influence of interference. Thus, the color is changed depending on the viewing angle. Such a phenomenon can be a problem in the case of white color to which human eyes have high sensitivity. The second problem is that the carrier balance is lost during the emission, changing the luminance of each color and thus varying the color.

The organic LED element of the present invention can use a fluorescent material as the scattering material or the base material. This can realize an effect of changing the color by conversion of wavelength through the emission from the organic layer. In this case, the chromaticity of the light emitted from the organic LED can be reduced, and the emitted light is scattered and extracted to thereby suppress the dependency of the color on the viewing angle and the change of the color over an elapse of time.

(First electrode)

The first electrode (anode) is required to have translucency of 80 % or more in order to externally extract light emitted from the organic layer 140. The first electrode is also required to have a high work function with a view to injection of many holes. More specifically, the first electrode is formed from a material such as ITO (Indium Tin Oxide), $SnO_2$, ZnO, IZO (Indium Zinc Oxide), AZO ($ZnO-Al_2O_3$: zinc oxide doped with aluminum), GZO ($ZnO-Ga_2O_3$: zinc oxide doped with gallium), Nb-doped $TiO_2$, or Ta-doped $TiO_2$. The thickness of the anode is preferably 100 nm or more. The refractive index of the anode 130 is 1.9 to 2.2. The refractive index of ITO can be reduced by increasing the carrier concentration. The commercially available ITO contains 10 wt% of $SnO_2$ according to the standards. The refractive index of ITO can be reduced by increasing the Sn concentration. But, such an increase in the carrier concentration by the increased Sn concentration leads to the reduction of mobility and transmittance. It is therefore necessary to determine the Sn content by keeping mobility and transmittance in balance.

Although the foregoing description is given mainly as to the first electrode used in the bottom emission type organic LED element, it is needless to say that the first electrode can also be used in the double-sided emission type organic LED element.

(Organic layer)

The organic layer 140, which is a layer having a light emission function, is composed of a hole injection layer, a hole transport layer, a light-emitting layer, an electron transport layer, and an electron injection layer. The refractive index of the organic layer 140 is 1.7 to 1.8.

The hole injection layer is required to have a small difference in ionization potential in order to lower the hole injection barrier from the anode. Enhancing the efficiency of the charge injection from the electrode interface in the hole injection layer not only reduces the driving voltage of the element but increases the efficiency of charge injection. As higher molecular materials used therefore, polyethylene dioxythiophene (PEDOT:PSS) doped with polystyrene sulfonic acid (PSS) is widely used, and as lower molecular materials used therefore, phthalocyanine-based copper phthalocyanine (CuPc) is widely used.

The hole transport layer has a function of transporting holes injected from the hole injection layer to the light-emitting layer. The hole transport layer is required to appropriately have an ionization potential and a hole mobility. As the hole transport layer, specific examples thereof include triphenylamine derivatives, N,N'-bis(1-naphthyl)-N,N'-diphenyl-1,1'-biphenyl-4,4'-diamine (NPD), N,N'-diphenyl-N,N'-bis[N-phenyl-N-(2-naphthyl)-4'-aminobiphenyl-4-yl]-1,1'-biphenyl-4,4'-diamine (NPTE), 1,1-bis[(di-4-tolylamino) phenyl]cyclohexane (HTM2), and N,N'-diphenyl-N,N'-bis(3-methylphenyl)-1,1'-diphenyl-4,4'-diamine (TPD). The thickness of the hole transport layer is preferably 10 to 150 nm. The voltage can be decreased with the thinner thickness of the hole transport layer. But, the thickness is particularly preferably 10 to 150 nm in the aspect of the problem associated with the short circuit between electrodes.

The light-emitting layer provides a field for recoupling the injected electron and hole and uses a material having high emission efficiency. More specifically, a light-emitting host material used in the light-emitting layer and a doping material of a light-emitting pigment function as a center for recoupling of holes and electrons which are injected from anode and cathode. The doping of the light-emitting pigment into the host material in the light-emitting layer results in high emission efficiency and a conversion of the light emission wavelength. These are required to have an appropriate energy level for injection of charges and have excellent chemical stability and thermal resistance, and have the property capable of forming a homogeneous amorphous thin film.

The light-emitting layer is also required to be excellent in kinds of light emission color and color purity, and to have high light emission efficiency. Examples of the light emitting materials which are organic materials include low molecular materials and high molecular materials. Moreover, depending on the light emission mechanism, these are classified into fluorescent materials and phosphorescent materials. Examples of the light emitting materials include metal complexes of quinoline derivatives, such as tris(8-quinolinolato) aluminum complex ($Alq_3$), bis(8-hydroxy) quinaldine aluminum phenoxide ($Alq'_2OPh$), bis(8-hydroxy) quinaldine aluminum-2,5-dimethylphenoxide (BAlq), mono(2,2,6,6-tetramethyl-3,5-heptanedionate) lithium complex (Liq), mono(8-quinolinolato) sodium complex (Naq), mono(2,2,6,6-tetramethyl-3,5-heptanedionate) lithium complex, mono(2,2,6,6-tetramethyl-3,5-heptanedionate) sodium complex, and bis(8-quinolinolato) calcium complex ($Caq_2$); or fluorescent materials, such as tetraphenylbutadiene, phenylquinacridone (QD), anthracene, perylene, or coronene. As the host materials, quinolinolate complexes are preferable, and particularly, 8-quinolinol and aluminum complexes having an 8-quinolinol derivative as a ligand are preferable.

The electron transport layer has a function of transporting electrons injected from the electrode. As the electron transport layer, specific examples thereof include quinolinol aluminum complexes ($Alq_3$), oxadiazole derivatives (e.g., 2,5-bis(1-naphthyl)-1,3,4-oxadiazole (BND), 2-(4-t-butylphenyl)-5-(4-biphenyl)-1,3,4-oxadiazole (PBD), etc.), triazole derivatives, bathophenanthroline derivatives, silole derivatives and the like.

The electron injection layer is required to increase electron injection efficiency. More specifically, as the electron injection layer, a layer obtained by doping a cathode interface with an alkali metal such as lithium (Li) or cesium (Cs) is provided.

(Second electrode)

As a reflective electrode (cathode) as the second electrode, a metal having a small work function or its alloy is used. The specific examples used for the cathode include alkali metals, alkaline earth metals, or metals belonging to Group 3 of the periodic table. Among them, aluminum (Al), magnesium (Mg), silver (Ag) or their alloys are preferably used, because they are inexpensive and superior in chemical stability. Further, a co-deposition film of Al and MgAg, or a laminated electrode prepared by deposition of Al on a LiF or $Li_2O$ thin deposition film can be used. As the high molecular material, a laminate of calcium (Ca) or barium (Ba) and aluminum (Al) can be used. Of course, the reflective electrode can also be used as the anode.

When the second electrode is used in the double-sided emission type second organic LED element, the second electrode is required to have translucency rather than reflectivity. Accordingly, in this case, the structure and characteristics of the second electrode are preferably the same as those of the first electrode.

(Glass for scattering layer)

Hereinafter, a detailed description will be given as to a glass for a scattering layer of an organic LED element according to the present invention.

The refractive index of the glass for the scattering layer is preferably equivalent to or higher than that of the translucent electrode material, as described above. Hence, the glass for the scattering layer is required to have a higher refractive index as possible. Further, the glass for the scattering layer is required to have a lower glass transition temperature as possible in order to prevent a thermal deformation of the substrate during the formation of the scattering layer by firing and softening the glass powder. The thermal expansion coefficient of the glass for the scattering layer is required to be closely equivalent to or slightly lower than that of the substrate in order to prevent cracks or warpage caused by the stress generated between the scattering layer and the substrate during the formation of the scattering layer. Generally, the thermal expansion coefficient of a glass having high refractive index and low transition temperature is considerably higher than that of the substrate. Hence, the glass for the scattering layer is required to have a low thermal expansion coefficient as possible. Warpage or crack is a great obstacle when forming the translucent electrode layer on the scattering layer.

Preferably, the glass for a scattering layer according to the present invention has a refractive index ($n_d$) of 1.75 to 2.20; a glass transition temperature (Tg) of 530 °C or less; and an average thermal expansion coefficient ($\alpha_{50-300}$) of $55\times10^{-7}$/K to $95\times10^{-7}$/K in the range of 50 to 300 °C.

The glass composition for a scattering layer according to the present invention includes, in terms of mol% on the basis of oxides thereof, 15 to 30 % of $P_2O_5$, 5 to 30 % of $Bi_2O_3$, 5 to 27 % of $Nb_2O_5$, and 4 to 40 % of ZnO, wherein the total content of alkali metal oxides consisting of $Li_2O$, $Na_2O$, and $K_2O$ is 5 mass% or less.

$P_2O_5$ is the essential ingredient that forms a network structure as the skeleton of the glass and provides the stability of the glass. When the content of $P_2O_5$ is less than 15 mol%, the devitrification is easily occurred. Hence, the content of $P_2O_5$ is preferably 19 mol% or more, more preferably 20 mol% or more. On the other hand, when the content of $P_2O_5$ is more than 30 mol%, it is difficult to acquire high refractive index. Hence, the content of $P_2O_5$ is preferably 28 mol% or less, more preferably 26 mol% or less.

$Bi_2O_3$ is the essential ingredient that imparts high refractive index and enhances the stability of the glass. When the content of $Bi_2O_3$ is less than 5 mol%, the effect is insufficiently achieved. Hence, the content of $Bi_2O_3$ is preferably 10 mol% or more, more preferably 13 mol% or more. On the other hand, when the content of $Bi_2O_3$ is more than 30 mol%, the thermal expansion coefficient is increased and the coloring is easily occurred. Hence, the content of $Bi_2O_3$ is preferably 28 mol% or less, more preferably 25 mol% or less.

$Nb_2O_5$ is the essential ingredient that imparts high refractive index and lowers the thermal expansion coefficient. When the content of $Nb_2O_5$ is less than 5 mol%, the effect is insufficiently achieved. Hence, the content of $Nb_2O_5$ is preferably 7 mol% or more, more preferably 10 mol% or more. On the other hand, when the content of $Nb_2O_5$ is more than 27 mol%, the glass transition temperature is increased and devitrification is easily occurred. Hence, the content of $Nb_2O_5$ is preferably 20 mol% or less, more preferably 18 mol% or less.

ZnO is the essential ingredient that suppresses an excessive increase of the thermal expansion coefficient, greatly lowers the glass transition temperature, and imparts high refractive index. In addition, ZnO has effects of lowering the viscosity of the glass and improving the formability. When the content of ZnO is less than 4 mol%, the effect is insufficiently achieved. Hence, the content of ZnO is preferably 16 mol% or more, more preferably 21 mol% or more. On the other hand, when the content of ZnO is more than 40 mol%, the tendency of devitrification of glass is increased. Hence, the content of ZnO is preferably 35 mol% or less, more preferably 30 mol% or less. Although the value represented by mol% is not necessarily the same as the value represented by mass%, when these are represented by mass%, the content thereof is preferably 7 mass% or more, more preferably 9 mass% or more.

Alkali metal oxides consisting of $Li_2O$, $Na_2O$ and $K_2O$ potentially cause an increase of the thermal expansion coefficient. Thus, it is preferred that the alkali metal oxides are not substantially contained (the content thereof is approximately zero). However, the alkali metal oxides have effects of imparting resistance to devitrification of the glass and lowering the glass transition temperature, and thus, the alkali metal oxides can be contained in an amount of up to 5 mass%.

Here, applying an electric field to an alkali metal in wet state may lead to the movement of the alkali metal, thereby breaking the terminal of the organic LED element. For this reason, the total content of the alkali metal oxides is preferably 5 mass% or less, more preferably 2 mass% or less. It is particularly preferred that the alkali metal oxides are not substantially contained (the content thereof is approximately zero).

In addition, $Na_2O$ and $K_2O$ increase the thermal expansion coefficient in comparison with the case of $Li_2O$. It is therefore preferred that, if an alkali metal oxide is contained, $Na_2O$ and $K_2O$ are not substantially contained (the contents thereof are approximately zero) and only the $Li_2O$ is used.

$TiO_2$ tends to increases the glass transition temperature and easily causes devitrification. Hence, it is preferred that $TiO_2$ is not substantially contained (the content thereof is approximately zero). But, $TiO_2$ which has an effect of imparting high refractive index may be contained in an amount of up to 8 mol%.

$B_2O_3$, which is not an essential ingredient, has an effect of enhancing the solubility of the glass. Hence, the content of $B_2O_3$ can be contained in an amount of up to 17 mol%. But, when the content of $B_2O_3$ is more than 17 mol%, devitrification or phase separation is easily caused and it is difficult to acquire high refractive index.

$WO_3$ is not an essential ingredient but has effects of imparting high refractive index without greatly changing the thermal expansion coefficient and the glass transition temperature. Hence, $WO_3$ may be contained in an amount of up to 20 mol%. But, when the content of $WO_3$ is more than 20 mol%, coloration is increased and devitrification is easily caused.

$TeO_2$ is not an essential ingredient but has effects of suppressing an excessive increase of the thermal expansion coefficient and lowering the glass transition temperature. $TeO_2$ may be contained in an amount of up to 7 mol%. However,

$TeO_2$ is expensive and potentially causes erosion of a platinum crucible, and thus, it is preferred that $TeO_2$ is not contained in a large amount.

$GeO_2$ is an optional ingredient which has an effect of imparting high refractive index, but is expensive. The content of $GeO_2$ is preferably 7 mol% or less. Although the value represented by mol% is not necessarily same as the value represented by mass%, when these are represented by mass%, the content thereof is preferably 4.5 mass% or less.

$ZrO_2$ is not an essential ingredient but has an effect of enhancing the stability of the glass. $ZrO_2$ may be contained in an amount of up to 7 mol%. But, when the content of $ZrO_2$ is more than 7 mol%, devitrification of the glass is easily caused.

$Sb_2O_3$ is not an essential ingredient, but is effect as a cleaning agent and has an effect of suppressing coloration. Hence, $Sb_2O_3$ may be contained in an amount of up to 2 mol%.

Alkaline earth metal oxides (MgO, CaO, SrO, and BaO) are not essential, but have an effect of improving the stability of the glass. Hence, the alkaline earth metal oxides may be contained in an amount of up to 10 mol%. But, when the content of the alkaline earth metal oxides is more than 10 mol%, the refractive index is reduced and the thermal expansion coefficient is increased.

The expression "does not substantially contain" means that the ingredient is not actively contained, but does not exclude the case where the ingredient is incorporated as impurities derived from other ingredients.

The glass of the present invention may also contain $SiO_2$, $Al_2O_3$, $La_2O_3$, $Y_2O_3$, $Gd_2O_3$, $Ta_2O_3$, $Cs_2O$, transition metal oxides or the like within the range of not impairing the effects of the present invention. The total content of these components is preferably less than 5 mol%, more preferably less than 3 mol%. Particularly preferably, these components are not substantially contained (the content thereof is approximately zero).

It is preferred that the glass of the present invention does not substantially contain a lead oxide, with a view to reducing the possibility of causing environmental pollution.

The glass of the present invention can be prepared by using ingredient materials such as oxides, phosphates, metaphosphates, carbonates, nitrates or hydroxides, weighing these so as to have a given composition, mixing them, melting the mixture in a crucible made of platinum or the like at a temperature of 950 to 1,500 °C, and quenching by casting them in a mold or pouring them into a space between a pair of rolls. A slow cooling may also be adopted thereby to eliminate strain. The glass thus prepared by the above-specified method is used in the form of a powder. The glass powder can be obtained by pulverizing the glass with a mortar, a ball mill, a jet mill, or the like and, if necessity, classifying them. The mass average particle size of the glass powder is typically 0.5 to 10 microns. The surface of the glass power may be modified with a surfactant or a silane coupling agent.

The transparent substrate with a scattering layer can be obtained by, if necessary, kneading with a solvent or a binder, applying them onto a transparent substrate, firing at a temperature higher than the glass transition temperature of the glass frit to soften the glass frit by about 60°C, and then cooling to a room temperature. Examples of the solvent include $\alpha$-terpineol, butyl carbitol acetate, phthalic acid ester, or 2,2,4-trimethyl-1,3-pentanediol monoisobutyrate. Examples of the binder include ethyl cellulose, acrylic resin, styrene resin, phenol resin, or butyral resin. Other ingredients than the solvent or the binder may also be contained within the range of not impairing objects of the present invention. In the case of using a binder, it is preferable to include a step of firing at a temperature lower than the glass transition temperature to gasify the binder, before softening the glass frit.

## Examples

### (Glass composition)

Examples 1 to 35 are the embodiments having the glass composition of the present invention.

Tables 1 to 8 present the glass composition in the individual examples in terms of mol%, and the measured refractive index ($n_d$), glass transition temperature (Tg), and average thermal expansion coefficient ($\alpha_{50\text{-}300}$) in the range of 50 to 300 °C. The compositions in terms of mass% which are calculated by converting based on the compositions in terms of mol% are also shown. In all glass, as ingredient materials for each component, oxides, metaphosphates, or carbonates were used. The ingredient materials were weighed so as to have the compositions shown in Table 1 after vitrification, followed by mixing them sufficiently. The mixture was melt in an electric furnace using a crucible made of platinum at a temperature of 950 to 1,350 °C, followed by casting them in a mold made of carbon, and then, the cast glass was cooled to the glass transition temperature, and immediately after that, it was put into an annealing furnace, and slowly cooled to a room temperature to thereby obtain each glass compositions..

The refractive index ($n_d$), glass transition temperature (Tg) and average thermal expansion coefficient ($\alpha_{50\text{-}300}$) in the range of 50 to 300°C of the glass thus obtained were measured as follows.

(1) Refractive index ($n_d$)

The glass was polished, and then the refractive index thereof was measured by using the V block method with a digital precise refractive index detector (KPR-2000, manufactured by Kalnew Optical Industries).

(2) Glass transition temperature (Tg)

The glass was processed into a cylindrical rod having a diameter of 5 mm and a length of 200 mm, and thus, the glass transition temperature thereof was measured at a temperature rising rate of 5 °C/min with a thermo-mechanical analyzer (TMA), TD500SA manufactured by Bruker AXS Corp.

(3) Average thermal expansion coefficient ($\alpha_{50\text{-}300}$) in the range of 50 to 300 °C

The glass was processed into a cylindrical rod having a diameter of 5 mm and a length of 200 mm, and thus, the glass transition temperature thereof was measured at a temperature rising rate of 5 °C/min with a thermo-mechanical analyzer (TMA), TD500SA manufactured by Bruker AXS Corp. Provided that the length of the glass rod at 50 °C was $L_{50}$ and the length of the glass rod at 300 °C was $L_{300}$, the average thermal expansion coefficient ($\alpha_{50\text{-}300}$) in the range of 50 to 300 °C was determined by the following equation:

$$\alpha_{50\text{-}300} = \{( L_{300}/L_{50}) - 1\}/(300 - 50)$$

Here, Examples 1 to 35 correspond to the embodiments of the present invention.

[Table 1]

| | 1 | 2 | 3 | 4 | 5 | 6 | 7 | 8 | 9 |
|---|---|---|---|---|---|---|---|---|---|
| | mol% | mol% | mol% | mol% | mol% | mol% | mol% | mol% | mol% |
| $P_2O_5$ | 21.9 | 20.5 | 20.0 | 19.7 | 21.7 | 22.1 | 19.7 | 15.9 | 25.1 |
| $Bi_2O_3$ | 15.7 | 14.7 | 17.3 | 14.2 | 15.6 | 13.9 | 12.9 | 20.9 | 16.4 |
| $Nb_2O_5$ | 16.7 | 19.0 | 13.9 | 15.0 | 16.5 | 14.8 | 13.7 | 12.0 | 17.3 |
| ZnO | 4.7 | 8.0 | 18.1 | 19.7 | 21.6 | 24.3 | 31.1 | 20.4 | 22.7 |
| $B_2O_3$ | 11.4 | 10.6 | 10.4 | 10.3 | 11.2 | 11.5 | 10.2 | 8.9 | 13.0 |
| $Li_2O$ | 11.5 | 10.3 | 5.2 | 4.8 | 3.7 | 4.7 | 4.3 | 5.0 | 5.5 |
| $Na_2O$ | | | | | | | | | |
| $K_2O$ | | | | | | | | | |
| $TiO_2$ | 8.2 | 7.7 | 6.9 | 7.4 | | | | 7.7 | |
| $WO_3$ | 9.9 | 9.2 | 8.2 | 8.9 | 9.7 | 8.7 | 8.1 | 9.2 | |
| $ZrO_2$ | | | | | | | | | |
| Others | | | | | | | | | |
| | | | | | | | | | |
| Total content of alkali metal oxides (mol%) | 11.5 | 10.3 | 5.2 | 4.8 | 3.7 | 4.7 | 4.3 | 5.7 | 5.5 |
| $n_d$ | 2.00 | 2.02 | 2.01 | 2.00 | 1.99 | 1.96 | 1.95 | 2.05 | 1.97 |
| $T_g$ [°C] | 483 | 483 | 476 | 483 | 479 | 474 | 468 | 463 | 480 |

(continued)

| | 1 | 2 | 3 | 4 | 5 | 6 | 7 | 8 | 9 |
|---|---|---|---|---|---|---|---|---|---|
| | mol% | mol% | mol% | mol% | mol% | mol% | mol% | mol% | mol% |
| a-$_{50-300}$ [$10^{-7}$/K] | 81 | 76 | 77 | 73 | 72 | 72 | 75 | 84 | 73 |

[Table 21

| | 1 | 2 | 3 | 4 | 5 | 6 | 7 | 8 | 9 |
|---|---|---|---|---|---|---|---|---|---|
| | wt% | wt% | wt% | wt% | wt% | wt% | wt% | wt% | wt% |
| $P_2O_5$ | 16.1 | 15.1 | 14.6 | 15.1 | 15.7 | 17.0 | 15.8 | 11.1 | 19.0 |
| $Bi_2O_3$ | 37.8 | 35.6 | 41.6 | 35.7 | 37.0 | 35.0 | 34.0 | 47.8 | 40.8 |
| $Nb_2O_5$ | 22.9 | 26.2 | 19.1 | 21.5 | 22.3 | 21.3 | 20.6 | 15.7 | 24.6 |
| ZnO | 2.0 | 3.4 | 7.6 | 8.7 | 9.0 | 10.7 | 14.3 | 8.2 | 9.9 |
| $B_2O_3$ | 4.1 | 3.8 | 3.7 | 3.9 | 4.0 | 4.3 | 4.0 | 3.0 | 4.8 |
| $Li_2O$ | 1.8 | 1.6 | 0.8 | 0.8 | 0.6 | 0.8 | 0.7 | 0.7 | 0.9 |
| $Na_2O$ | | | | | | | | | |
| $K_2O$ | | | | | | | | | |
| $TiO_2$ | 3.4 | 3.2 | 2.8 | 3.2 | | | | 3.0 | |
| $WO_3$ | 11.9 | 11.1 | 9.8 | 11.1 | 11.4 | 10.9 | 10.6 | 10.5 | |
| $ZrO_2$ | | | | | | | | | |
| Others | | | | | | | | | |
| | | | | | | | | | |
| Total content of alkali metal oxides (wt%) | 1.8 | 1.6 | 0.8 | 0.8 | 0.6 | 0.8 | 0.7 | 0.7 | 0.9 |

[Table 3]

| | 10 | 11 | 12 | 13 | 14 | 15 | 16 | 17 | 18 |
|---|---|---|---|---|---|---|---|---|---|
| | mol% | mol% | mol% | mol% | mol% | mol% | mol% | mol% | mol% |
| $P_2O_5$ | 27.7 | 25.8 | 24.3 | 21.9 | 20.0 | 21.1 | 19.3 | 25.0 | 19.3 |
| $Bi_2O_3$ | 16.4 | 16.8 | 15.3 | 14.3 | 23.0 | 15.1 | 22.3 | 6.4 | 22.0 |
| $Nb_2O_5$ | 17.4 | 17.9 | 16.2 | 15.2 | 11.2 | 16.0 | 10.8 | 17.3 | 15.2 |
| ZnO | 22.7 | 23.3 | 26.7 | 19.9 | 25.1 | 21.0 | 24.3 | 22.6 | 10.7 |
| $B_2O_3$ | | | 2.8 | 14.9 | 11.7 | 10.9 | 11.3 | 13.0 | 10.0 |
| $Li_2O$ | 5.5 | 5.7 | 5.1 | 4.8 | | | | 5.5 | 4.3 |
| $Na_2O$ | | | | | | 6.4 | | | |
| $K_2O$ | | | | | | | 3.3 | | |
| $TiO_2$ | | | | | | | | | 10.6 |
| $WO_3$ | 10.3 | 10.5 | 9.4 | 9.0 | 9.0 | 9.5 | 8.7 | 10.2 | 7.9 |

(continued)

| | 10 | 11 | 12 | 13 | 14 | 15 | 16 | 17 | 18 |
|---|---|---|---|---|---|---|---|---|---|
| | mol% | mol% | mol% | mol% | mol% | mol% | mol% | mol% | mol% |
| $ZrO_2$ | | | | | | | | | |
| Others | | | $Sb_2O_3$ 0.2 | | | | | | |
| | | | | | | | | | |
| Total content of alkali metal oxides (mol%) | 6.4 | 5.7 | 5.1 | 4.8 | | 6.4 | 3.3 | 5.5 | 4.3 |
| $n_d$ | 1.99 | 2.01 | 1.99 | 1.96 | 2.00 | 1.97 | 1.99 | 1.89 | 2.08 |
| $T_g$[°C] | 485 | 486 | 475 | 485 | 487 | 482 | 480 | 490 | 488 |
| $a_{50-300}$ [$10^{-7}$/K] | 80 | 79 | 75 | 69 | 80 | 78 | 85 | 61 | 75 |

[Table 4]

| | 10 | 11 | 12 | 13 | 14 | 15 | 16 | 17 | 18 |
|---|---|---|---|---|---|---|---|---|---|
| | wt% | wt% | wt% | wt% | wt% | wt% | wt% | wt% | wt% |
| $P_2O_5$ | 19.1 | 17.7 | 17.5 | 16.6 | 13.2 | 15.5 | 13.0 | 21.6 | 12.8 |
| $Bi_2O_3$ | 37.1 | 37.7 | 36.3 | 35.6 | 49.9 | 36.4 | 49.2 | 18.2 | 47.9 |
| $Nb_2O_5$ | 22.4 | 23.0 | 21.9 | 21.6 | 13.9 | 22.0 | 13.6 | 28.1 | 18.9 |
| ZnO | 9.0 | 9.1 | 11.1 | 8.7 | 9.5 | 8.8 | 9.4 | 11.2 | 4.1 |
| $B_2O_3$ | | | 1.0 | 5.5 | 3.8 | 3.9 | 3.7 | 5.5 | 3.2 |
| $Li_2O$ | 0.8 | 0.8 | 0.8 | 0.8 | | | | 1.0 | 0.6 |
| $Na_2O$ | | | | | | 2.0 | | | |
| $K_2O$ | | | | | | | 1.5 | | |
| $TiO_2$ | | | | | | | | | 3.9 |
| $WO_3$ | 11.6 | 11.7 | 11.1 | 11.2 | 9.7 | 11.4 | 9.6 | 14.4 | 8.6 |
| $ZrO_2$ | | | | | | | | | |
| Others | | | $Sb_2O_3$ 0.3 | | | | | | |
| | | | | | | | | | |
| Total content of alkali metal oxides (wt%) | 0.8 | 0.8 | 0.8 | 0.8 | | 2.0 | 1.5 | 1.0 | 0.6 |

[Table 5]

| | 19 | 20 | 21 | 22 | 23 | 24 | 25 | 26 | 27 |
|---|---|---|---|---|---|---|---|---|---|
| | mol% | mol% | mol% | mol% | mol% | mol% | mol% | mol% | mol% |
| $P_2O_5$ | 21.7 | 22.5 | 20.4 | 20.1 | 21.7 | 21.0 | 21.0 | 21.0 | 21.0 |
| $Bi_2O_3$ | 22.2 | 14.7 | 13.3 | 14.5 | 14.2 | 13.7 | 13.7 | 13.7 | 13.7 |
| $Nb_2O_5$ | 6.4 | 25.4 | 14.2 | 15.3 | 15.0 | 14.5 | 14.5 | 14.5 | 14.5 |
| ZnO | 27.2 | 11.5 | 18.5 | 9.6 | 19.6 | 19.0 | 19.0 | 19.0 | 19.0 |
| $B_2O_3$ | 12.7 | 11.7 | 10.6 | 10.4 | 11.3 | 10.9 | 10.9 | 10.9 | 10.9 |
| $Li_2O$ | | 5.0 | 4.5 | 8.3 | 4.8 | 4.6 | 4.6 | 4.6 | 4.6 |
| $Na_2O$ | | | | | | | | | |
| $K_2O$ | | | | | | | | | |
| $TiO_2$ | | | | 7.6 | | | | | |
| $WO_3$ | 9.8 | 9.2 | 18.5 | 9.0 | 8.9 | 8.6 | 8.6 | 8.6 | 8.6 |
| $ZrO_2$ | | | | | | | | | |
| Others | | | | $TeO_2$ 5.2 | $GeO_2$ 4.5 | MgO 7.7 | CaO 7.7 | SrO 7.7 | BaO 7.7 |
| | | | | | | | | | |
| Total content of alkali metal oxides (mol%) | | 5.0 | 4.5 | 8.3 | 4.8 | 4.6 | 4.6 | 4.6 | 4.6 |
| $n_d$ | 1.98 | 2.02 | 1.98 | 1.99 | 1.95 | 1.95 | 1.95 | 1.95 | 1.95 |
| $T_g$[°C] | 483 | 490 | 478 | 470 | 477 | 483 | 482 | 483 | 484 |
| $a_{50-300}$ [$10^{-7}$/K] | 82 | 68 | 72 | 85 | 73 | 77 | 81 | 81 | 84 |

[Table 6]

| | 19 | 20 | 21 | 22 | 23 | 24 | 25 | 26 | 27 |
|---|---|---|---|---|---|---|---|---|---|
| | wt% | wt% | wt% | wt% | wt% | wt% | wt% | wt% | wt% |
| $P_2O_5$ | 15.0 | 15.3 | 14.8 | 15.1 | 16.4 | 16.7 | 16.7 | 16.4 | 16.3 |
| $Bi_2O_3$ | 50.5 | 32.9 | 31.7 | 35.6 | 35.3 | 35.8 | 35.7 | 35.2 | 34.8 |
| $Nb_2O_5$ | 8.3 | 32.4 | 19.3 | 21.5 | 21.3 | 21.6 | 21.5 | 21.3 | 21.0 |
| ZnO | 10.8 | 4.5 | 7.7 | 4.1 | 8.5 | 8.7 | 8.6 | 8.5 | 8.4 |
| $B_2O_3$ | 4.3 | 3.9 | 3.8 | 3.8 | 4.2 | 4.2 | 4.2 | 4.2 | 4.1 |
| $Li_2O$ | | 0.7 | 0.7 | 1.3 | 0.8 | 0.8 | 0.8 | 0.8 | 0.7 |
| $Na_2O$ | | | | | | | | | |
| $K_2O$ | | | | | | | | | |
| $TiO_2$ | | | | 3.2 | | | | | |
| $WO_3$ | 11.1 | 10.3 | 22.0 | 11.0 | 11.0 | 11.2 | 11.1 | 11.0 | 10.9 |

(continued)

| | 19 | 20 | 21 | 22 | 23 | 24 | 25 | 26 | 27 |
|---|---|---|---|---|---|---|---|---|---|
| | wt% | wt% | wt% | wt% | wt% | wt% | wt% | wt% | wt% |
| $ZrO_2$ | | | | | | | | | |
| Others | | | | $TeO_2$ 4.4 | $GeO_2$ 2.5 | MgO 1.0 | CaO 1.4 | SrO 2.6 | BaO 3.8 |
| | | | | | | | | | |
| Total content of alkali metal oxides (wt%) | | 0.7 | 0.7 | 1.3 | 0.8 | 0.8 | 0.8 | 0.8 | 0.7 |

[Table 7]

| | 28 | 29 | 30 | 31 | 32 | 33 | 34 | 35 |
|---|---|---|---|---|---|---|---|---|
| | mol% | mol% | mol% | mol% | mol% | mol% | mol% | mol% |
| $P_2O_5$ | 24.0 | 22.0 | 22.5 | 23.3 | 22.5 | 23.9 | 23.7 | 23.9 |
| $Bi_2O_3$ | 15.7 | 11.6 | 14.7 | 15.2 | 28.0 | 15.6 | 20.6 | 15.6 |
| $Nb_2O_5$ | 16.6 | 18.5 | 15.6 | 16.1 | 10.7 | 16.4 | 16.2 | 16.6 |
| ZnO | 28.0 | 26.6 | 39.9 | 27.2 | 25.1 | 21.6 | 21.4 | 21.7 |
| $B_2O_3$ | 12.5 | 11.3 | 7.3 | 12.1 | 5.7 | 12.4 | 12.0 | 12.4 |
| $Li_2O$ | | 5.0 | | | | 5.2 | | |
| $Na_2O$ | | 5.0 | | | | | | |
| $K_2O$ | | | | | | | | |
| $TiO_2$ | | | | | | | | |
| $WO_3$ | 3.2 | | | 3.1 | 8.0 | | | 9.8 |
| $ZrO_2$ | | | | 3.0 | | 4.9 | 6.1 | |
| Others | | | | | | | | |
| | | | | | | | | |
| Total content of alkali metal oxides (mol%) | | 10 | | | | 5.2 | | |
| $n_d$ | 1.93 | 1.91 | 1.94 | 1.94 | 2.05 | 1.93 | 1.95 | 1.96 |
| $T_g$[°C] | 494 | 461 | 489 | 498 | 482 | 482 | 505 | 505 |
| $a_{50-300}$ [$10^{-7}$/K] | 66 | 79 | 70 | 65 | 86 | 70 | 67 | 65 |

[Table 8]

| | 28 | 29 | 30 | 31 | 32 | 33 | 34 | 35 |
|---|---|---|---|---|---|---|---|---|
| | wt% | wt% | wt% | wt% | wt% | wt% | wt% | wt% |
| $P_2O_5$ | 17.9 | 18.5 | 17.8 | 17.6 | 13.7 | 18.4 | 16.3 | 17.0 |
| $Bi_2O_3$ | 38.5 | 32.2 | 38.2 | 37.7 | 55.9 | 39.6 | 46.7 | 36.5 |
| $Nb_2O_5$ | 23.1 | 29.1 | 23. 1 | 22.7 | 12.1 | 23.7 | 20.9 | 22.0 |
| ZnO | 12.0 | 12.8 | 18.1 | 11.7 | 8.7 | 9.5 | 8.5 | 8.8 |

(continued)

| | 28 | 29 | 30 | 31 | 32 | 33 | 34 | 35 |
|---|---|---|---|---|---|---|---|---|
| | wt% | wt% | wt% | wt% | wt% | wt% | wt% | wt% |
| $B_2O_3$ | 4.6 | 4.7 | 2.8 | 4.5 | 1.7 | 4.7 | 4.0 | 4.3 |
| $Li_2O$ | | 0.9 | | | | 0.8 | | |
| $Na_2O$ | | 1.8 | | | | | | |
| $K_2O$ | | | | | | | | |
| $TiO_2$ | | | | | | | | |
| $WO_3$ | 3.9 | | | 3.8 | 7.9 | | | 11.4 |
| $ZrO_2$ | | | | 2.0 | | 3.3 | 3.6 | |
| Others | | | | | | | | |
| | | | | | | | | |
| Total content of alkali metal oxides (wt%) | | 2.7 | | | | 0.8 | | |

(Evaluation in regard to adhesion with substrate and warpage)

In Examples 36 and 37, the glass composition of the present invention was prepared on a substrate and the degree of the adhesion with substrate and warpage was evaluated.

The flaky glass having the compositions shown in Examples 4 and 5 was prepared, respectively, in the same manner as described above by weighing, mixing, melting, and quenching by pouring the mixture into a space between a pair of rolls. Each flaky glass was dry-pulverized with a ball mill made of alumina for one hour to obtain a glass frit, respectively. The mass average particle size of each glass frit was about 3 microns. 75 g of each glass frit obtained was kneaded with 25 g of an organic vehicle (10 mass% of ethyl cellulose dissolved in $\alpha$-terpineol) to prepare a glass paste. The glass paste was uniformly printed with 9 cm square at the center of a soda lime glass substrate which had been surface-coated with a silica film and had 10 cm square and a thickness of 0.55 mm, so that the film thickness after firing was 30 $\mu$m. This was dried at 150 °C for 30 minutes, cooled to a room temperature, heated up to 450 °C over 30 minutes, kept at 450 °C for 30 minutes, heated again up to 550 °C over 12 minutes, kept at 550 °C for 30 minutes, and then cooled to a room temperature over 3 hours, thereby forming a fired layer of the glass frit on the soda lime glass substrate. The fired layer and the substrate were observed to determine the occurrence of cracks. In addition, an average value of warpage of the substrate was determined by measuring the warpage at the four corners of the fired layer. The measurement results are presented in Table 9. The average thermal expansion coefficient ($\alpha_{50-300}$) in the range of 50 to 300 °C of the soda lime glass used was $83\times10^{-7}$/K.

[Table 9]

| | 36 | 37 |
|---|---|---|
| Composition of glass frit | Example 4 | Example 4 |
| Adhesion with substrate | Good | Good |
| Cracks on substrate | None | None |
| Average value of warpage at four corners of fired layer | 0.00mm (Acceptable) | 0.00mm (Acceptable) |

As apparent from the results, the glass for a scattering layer of an organic LED element according to the present invention is good in adhesion with the substrate, does not cause warpage or cracks on the substrate, and thus it is understood to be suitable for a scattering layer of an organic LED element.

(Evaluation of enhanced efficiency of light extraction)

The evaluation test for determining the enhancement of the efficiency of light extraction is described as follows. First, the soda lime glass manufactured by Asahi Glass Co., Ltd was used as the glass substrate. The scattering layer was prepared as follows. Powder materials were mixed so as to have the glass composition shown in Table 10.

[Table 101

| | mol% | wt% |
|---|---|---|
| $P_2O_5$ | 22.7 | 16.8 |
| $Bi_2O_3$ | 14.9 | 36.3 |
| $Nb_2O_5$ | 15.7 | 21.8 |
| ZnO | 20.6 | 8.7 |
| $B_2O_3$ | 11.8 | 4.3 |
| $Li_2O$ | 5.0 | 0.8 |
| $WO_3$ | 9.3 | 11.3 |

The mixture of the powder materials was melted in an electric furnace at 1,050 °C for 90 minutes, followed by keeping at 950 °C for 60 minutes, and then casting on rolls to prepare a flaky glass. The glass had a glass transition temperature of 475 °C, a yield point of 525 °C, and a thermal expansion coefficient of $72\times10^{-7}$ (1/°C) (as an average value in the range of 50 to 300 °C). The measurement was conducted by a thermal expansion method with a thermal analyzer (trade name: TD5000SA, manufactured by Bruker Corp.) at a temperature rising rate of 5 °C/min. The refractive index nF at F line (486.13 nm) was 2.00; the refractive index nd at d line (587.56 nm) was 1.98; and the refractive index nC at C line (656.27 nm) was 1.97. The measurement was conducted with a refractometer (trade name: KPR-2000, manufactured by Kalnew Optical Industrial Co., Ltd.).

The flake prepared was pulverized with a planetary mill made of zirconia for 2 hours, followed by sieving to obtain a glass powder. As for the particle size distribution thereof, D50 was 2.15 μm; D10 was 0.50 μm; and D90 was 9.72 μm. 35 g of the glass powder thus obtained was kneaded with 13.1 g of an organic vehicle (ethyl cellulose dissolved in α-terpineol or the like) to prepare a glass paste. The glass paste was uniformly printed on the aforementioned glass substrate in a circle with a diameter of 10 mm so as to have a film thickness of 14 μm after firing. This was dried at 150 °C for 30 minutes, cooled back to a room temperature, heated up to 450 °C over 45 minutes, and kept at 450 °C for 30 minutes, thereby completing the firing. This was heated up to 580 °C over 13 minutes, kept at 580 °C for 30 minutes, and then cooled to a room temperature over 3 hours. In this manner, a scattering layer was formed on the glass substrate.

In order to evaluate the characteristics of the glass substrate with a scattering layer, measurements were conducted in regard to haze and surface waviness.

The haze measurement was conducted using a haze computer (trade name: HZ-2, manufactured by Suga Test Instruments Co., Ltd.) and using a single body of the glass substrate as a standard sample. In other words, the single body of the glass substrate was constructed to have the total light transmittance of 100 and a haze of 0. As a result of the measurement, the total light transmittance was 79, and the haze value was 52.

The surface waviness was then measured. In the roughness measurement, the measurement instrument was a surface roughness measuring instrument (trade name: SURFCORDER ET4000A, manufactured by Kosaka Laboratory Ltd.), with a test length of 5.0 mm, a cutoff wavelength of 2.5 mm, and a measurement rate of 0.1 mm/s. As a result, the arithmetic average roughness Ra was 0.55 μm, and the arithmetic average wavelength λa was 193 μm. These numerical values are given according to the ISO 4287-1997 standard.

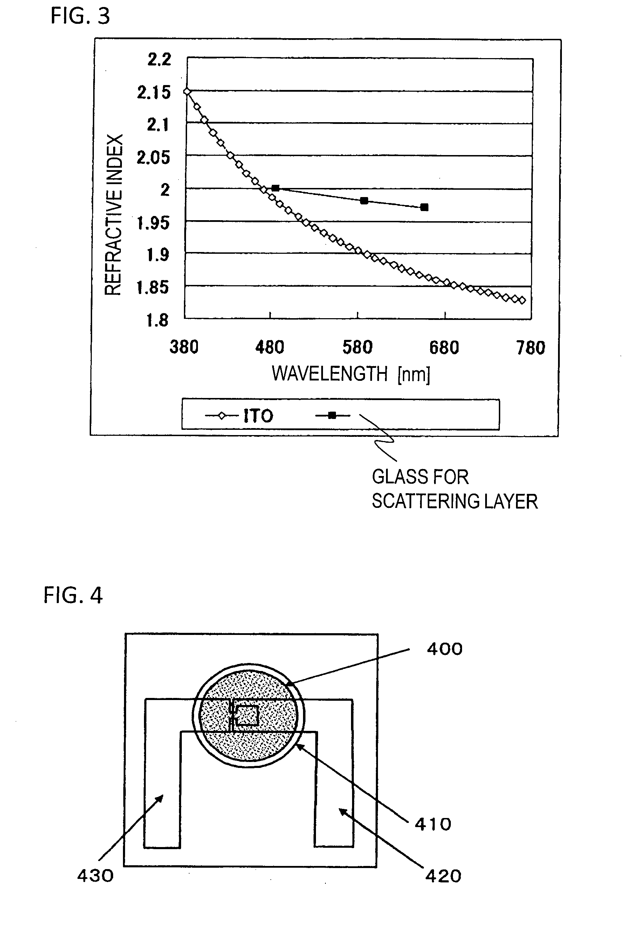

The aforementioned glass substrate with a scattering layer and a glass substrate without a scattering layer were prepared to fabricate organic EL elements, respectively. Firstly, an ITO film was formed to have a thickness of 150 nm as a translucent electrode, using a DC magnetron sputter. In the sputtering process, a mask was used to form the ITO film in a desired shape. FIG. 3 shows the refractive index of the ITO film and that of the aforementioned glass for a scattering layer. In the figure, the vertical axis indicates the refractive index, and the horizontal axis indicates the wavelength (unit: nm). Subsequently, these were subjected to ultrasonic cleaning with pure water and IPA, followed by exposing to the ultraviolet (UV) light using an excimer UV generator, thereby cleaning the surface thereof. Then, a vacuum depositor was used to form a 100nm-thick film of α-NPD (N,N'-diphenyl-N,N'-bis(1-napththyl)-1,1'-biphenyl-4,4'-diamine: CAS No. 123847-85-4), a 60nm-thick film of Alq3 (tris-8-hydroxyquinoline aluminum: CAS No. 2085-33-8), a 0.5nm-thick film of LiF, and a 80nm-thick film of Al. In this regard, α-NPD and Alq3 were formed in a circular pattern having a diameter of 12 mm using a mask, and LiF and Al were formed in a pattern using a mask having an area of 2 mm□ on the ITO pattern through the organic film. In this manner, an element substrate was completed.

Subsequently, a glass substrate (strain point of 570 °C or more, PD200 manufactured by Asahi Glass Co., Ltd.) separately prepared was processed by sandblasting to partially form concave portions, thereby forming a counter substrate. A photosensitive epoxy resin was coated on a dam surrounding the concave portions for peripheral sealing.

The element substrate and the counter substrate were placed in a glove box under the nitrogen atmosphere. After a water-repelling material containing CaO was adhered to the concave portions of the counter substrate, the element substrate and the counter substrate were laminated together and the laminate was exposed to the UV light to cure the resin for peripheral sealing, thereby completing an organic EL element.

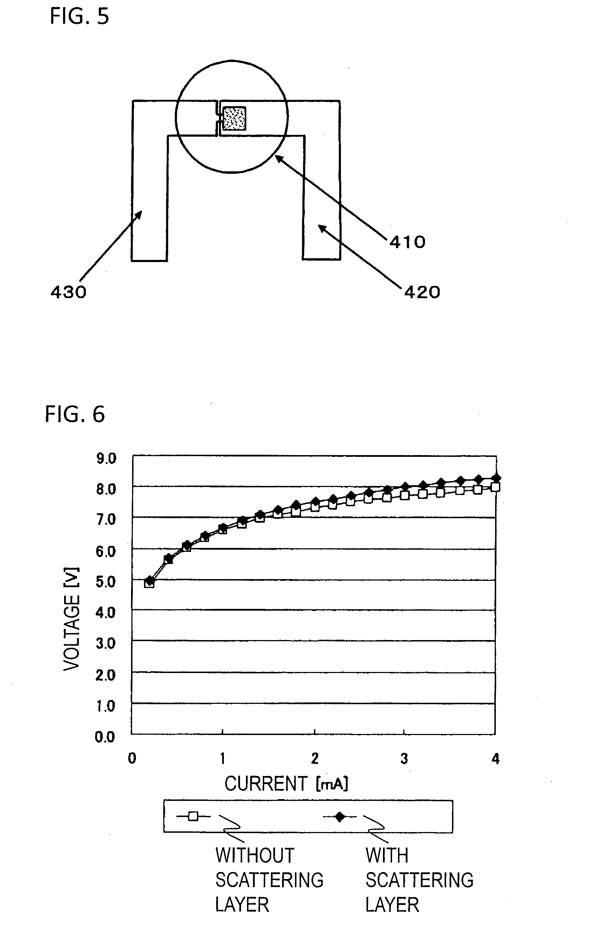

FIGs. 4 and 5 show aspects where the element emits light. FIG. 4 shows an element with a scattering layer; and FIG. 5 shows an element without a scattering layer. In the figures, numeral reference 400 denotes a scattering layer, numeral reference 410 denotes an organic layer, numeral reference 420 denotes an ITO pattern, and numeral reference 430 denotes an Al pattern. In the element without a scattering layer, light emission is observed only in the area of about 2 mm□ which was formed by intersection of the ITO pattern and the Al pattern. On the other hand, in the element formed on a scattering layer, light was extracted into the atmosphere from the peripheral region of the formed scattering layer as well as from the above area of about 2 mm□.

Subsequently, the elements were measured in regard to optical characteristics.

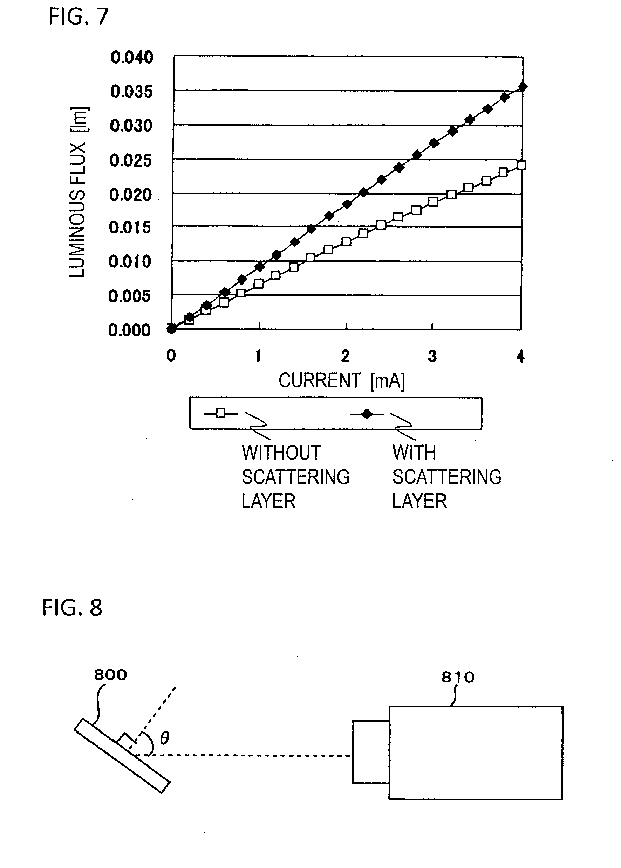

An EL characteristic measuring instrument (C9920-12, manufactured by Hamamatsu Photonics K.K.) was used to measure the total luminous flux. FIG. 6 shows a current-voltage characteristic for the element with a scattering layer and the element without a scattering layer. In the figure, the vertical axis indicates the voltage (unit: V), and the horizontal axis indicates the current (unit: mA). It is clear that the current-voltage characteristic was almost the same in the two types of elements, and the element formed on a scattering layer had no large leakage current. FIG. 7 shows a current-luminous flux characteristic. In the figure, the vertical axis indicates the luminous flux (unit: 1m), and the horizontal axis indicates the current (unit: mA). The luminous flux was in proportion to the current, regardless of the presence or absence of the scattering layer. The element with a scattering layer had higher luminous flux by 51 % than the element without a scattering layer. The reason of this result lies in that, as shown in FIG. 3, the refractive index of the scattering layer is higher than that of ITO as the translucent electrode in the range of emission wavelength (470 to 700 nm) of Alq3, and thus, the total reflection of the EL emission light of Alq3 from the interface between the ITO and the scattering layer is suppressed, thereby achieving light extraction into the atmosphere with efficiency.

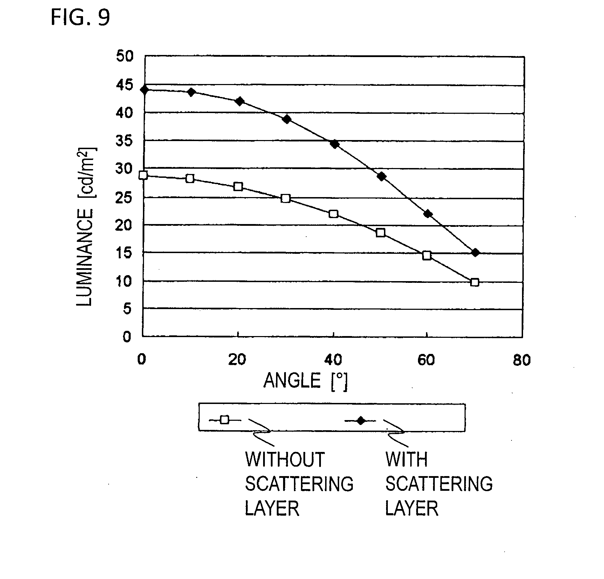

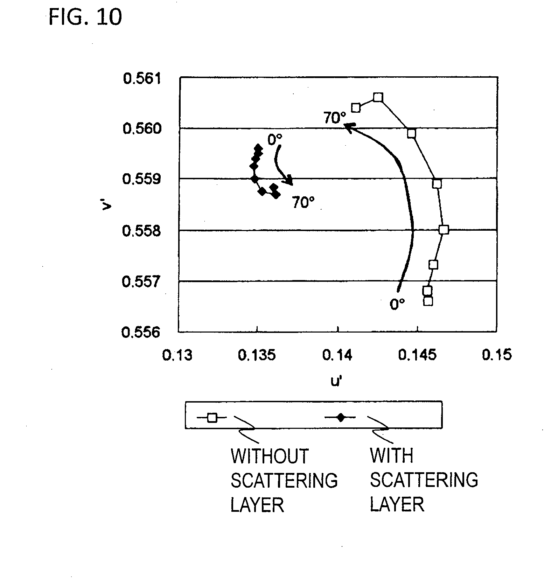

The dependency of light emission on the angle was evaluated. For the evaluation, a luminance colorimeter (trade name: BM-7A, manufactured by Topcon Technohouse Corp.) was used to measure the luminance of the emitted light and the dependency of the emitted light color on the angle, while the element was rotated against the luminance colorimeter, as shown in FIG. 8. In the figure, reference numeral 800 denotes a test element to be evaluated, and reference numeral 810 denotes a spectroscope. In the measurement, a current of 1 mA was applied to the element to turn the light on. The term "angle" as used herein refers to the measurement angle $\theta$ [°] formed by a normal direction of the element and a direction from the element toward the luminance colorimeter, as shown in FIG. 8. In other words, the state where the luminance colorimeter is positioned in front of the element means the angle of 0°. FIG. 9 shows the luminance data obtained from the measurement. In the figure, the vertical axis indicates the luminance (unit: $cd/m^2$), and the horizontal axis indicates the angle (unit: °). FIG. 10 also shows the chromaticity data obtained from the measurement. In the figure, V' is the vertical axis; and U' is the horizontal axis. The CIE 1976 UCS color system was used to calculate the chromaticity coordinates.

As can be seen from the luminance data of FIG. 9, the element with a scattering layer had higher luminance than the element without a scattering layer at any angle of measurement. Further, when the total luminous flux was given by an integral of the luminous data as a function of each solid angle, it was confirmed that the element with a scattering layer had higher luminous flux by 54 % than the element without a scattering layer. This showed almost the same results of the aforementioned measurement of the total luminous flux, demonstrating that the scattering layer greatly contributed to an increase of the luminous flux of the element.

As can be seen from the chromaticity data of FIG. 10, the change of chromaticity depending on the angle of measurement was small in the element with a scattering layer, while the change thereof was considerably large in the element without a scattering layer. This showed that the scattering layer provide in the element contributed not only to the improvement of an efficiency of light extraction, which is an original object of the present invention, but to the relaxation of the change of color by the angle. The small change of color by the angle leads to a large merit that the viewing angle is not limited for the light emission element.

While the invention has been described in detail and with reference to specific embodiments thereof, it will be apparent to one skilled in the art that various changes and modifications can be made therein without departing from the spirit and scope of the invention.

This application is based on Japanese patent application No. 2010-167093 filed on July 26, 2010, the contents of which are incorporated herein by reference.

Industrial Applicability

According to the present invention, a glass for a scattering layer used in an organic LED element, or an organic LED element using the scattering layer can be provided. The use of the organic LED element can improve the efficiency of light extraction.

Description of Reference Numerals and Signs

| | |
|---|---|
| 110 | Transparent substrate |
| 120 | Scattering layer |
| 130 | First electrode |
| 140 | Organic layer |
| 150, 210 | Second electrode |

**Claims**

**1.** A glass for a scattering layer of an organic LED element, comprising, in terms of mol% on the basis of oxides thereof:

15 to 30 % of $P_2O_5$;
5 to 30 % of $Bi_2O_3$;
5 to 27 % of $Nb_2O_5$; and
4 to 40 % of ZnO,

wherein a total content of alkali metal oxides consisting of $Li_2O$, $Na_2O$, and $K_2O$ is 5 mass% or less.

**2.** The glass for a scattering layer of an organic LED element according to claim 1, wherein the total content of the alkali metal oxides is 2 mass% or less.

**3.** The glass for a scattering layer of an organic LED element according to claim 1 or 2, which does not substantially contain the alkali metal oxides.

**4.** The glass for a scattering layer of an organic LED element according to any one of claims 1 to 3, which does not substantially contain $TiO_2$.

**5.** The glass for a scattering layer of an organic LED element according to any one of claims 1 to 4, which contains the ZnO in an amount of 21 mol% or more.

**6.** The glass for a scattering layer of an organic LED element according to any one of claims 1 to 5, which does not substantially contain a lead oxide.

**7.** An organic LED element, comprising a transparent substrate, a first electrode, an organic layer, and a second electrode in this order,
which comprises a scattering layer comprising, in terms of mol% on the basis of oxides thereof:15 to 30 % of $P_2O_5$; 5 to 30 % of $Bi_2O_3$; 5 to 27 % of $Nb_2O_5$; 4 to 40 % of ZnO, wherein a total content of alkali metal oxides consisting of $Li_2O$, $Na_2O$, and $K_2O$ is 5 mass% or less.

**8.** The organic LED element according to claim 7, wherein the scattering layer is placed on the transparent substrate.

**9.** The organic LED element according to claim 7, wherein the scattering layer is placed on the organic layer.

**10.** The organic LED element according to any one of claims 7 to 9, wherein the first and second electrodes are a transparent electrode.

**11.** The organic LED element according to any one of claims 7 to 10, which is used for lighting.

FIG. 1

150
140
130
121
122
120
110

FIG. 2

210
140
130
121
122
120
110

FIG. 3

2.2
2.15
2.1
2.05
2
1.95
1.9
1.85
1.8
REFRACTIVE INDEX
380
480
580
680
780
WAVELENGTH [nm]
ITO
GLASS FOR
SCATTERING LAYER

FIG. 4

400
410
420
430

FIG. 5

410
420
430

FIG. 6

9.0
8.0
7.0
6.0
5.0
4.0
3.0
2.0
1.0
0.0
VOLTAGE [V]
0
1
2
3
4
CURRENT [mA]
WITHOUT SCATTERING LAYER
WITH SCATTERING LAYER

FIG. 7

0.040
0.035
0.030
0.025
0.020
0.015
0.010
0.005
0.000
LUMINOUS FLUX [lm]
0
1
2
3
4
CURRENT [mA]
WITHOUT SCATTERING LAYER
WITH SCATTERING LAYER

FIG. 8

800
810
θ

FIG. 9

50
45
40
35
30
25
20
15
10
5
0
LUMINANCE [cd/m2]
0
20
40
60
80
ANGLE [°]
WITHOUT SCATTERING LAYER
WITH SCATTERING LAYER

FIG. 10

0.561
0.560
0.559
0.558
0.557
0.556
v'
0.13
0.135
0.14
0.145
0.15
u'
0°
70°
70°
0°
WITHOUT SCATTERING LAYER
WITH SCATTERING LAYER

## INTERNATIONAL SEARCH REPORT

International application No.
PCT/JP2011/066726

A. CLASSIFICATION OF SUBJECT MATTER
*H05B33/02*(2006.01)i, *C03C3/19*(2006.01)i, *C03C3/21*(2006.01)i, *H01L51/50*(2006.01)i

According to International Patent Classification (IPC) or to both national classification and IPC

B. FIELDS SEARCHED

Minimum documentation searched (classification system followed by classification symbols)
H05B33/02, C03C3/19, C03C3/21, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2010/041611 A1 (Asahi Glass Co., Ltd.), 15 April 2010 (15.04.2010), paragraphs [0002], [0060], [0068], [0128] to [0144], [0242] to [0251], [0258]; claims; drawings (Family: none) | 1-11 |
| P,X | WO 2010/084922 A1 (Asahi Glass Co., Ltd.), 29 July 2010 (29.07.2010), paragraphs [0027] to [0047]; claims; drawings (Family: none) | 1-11 |
| P,X | WO 2010/084925 A1 (Asahi Glass Co., Ltd.), 29 July 2010 (29.07.2010), paragraphs [0008], [0011] to [0029], [0035] to [0040]; claims; drawings (Family: none) | 1-11 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 11 August, 2011 (11.08.11) | 06 September, 2011 (06.09.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/066726

C (Continuation). DOCUMENTS CONSIDERED TO BE RELEVANT

| Category* | Citation of document, with indication, where appropriate, of the relevant passages | Relevant to claim No. |
|---|---|---|
| A | WO 2009/017035 A1 (Asahi Glass Co., Ltd.), 05 February 2009 (05.02.2009), paragraphs [0063] to [0079]; claims; drawings & US 2009/0153972 A1 & EP 2178343 A1 & CN 101766052 A & KR 10-2010-0051631 A | 1-11 |
| A | WO 2009/060916 A1 (Asahi Glass Co., Ltd.), 14 May 2009 (14.05.2009), paragraphs [0070] to [0086]; claims; drawings & US 2010/0230667 A & EP 2219416 A1 & CN 101855939 A & KR 10-2010-0101076 A | 1-11 |
| P,A | WO 2010/084923 A1 (Asahi Glass Co., Ltd.), 29 July 2010 (29.07.2010), paragraphs [0081] to [0097]; claims; drawings (Family: none) | 1-11 |
| P,A | JP 2010-170969 A (Asahi Glass Co., Ltd.), 05 August 2010 (05.08.2010), claims; paragraphs [0099] to [0115] & US 2010/0187987 A1 | 1-11 |
| P,A | WO 2011/046156 A1 (Asahi Glass Co., Ltd.), 21 April 2011 (21.04.2011), paragraphs [0051] to [0068]; claims; drawings (Family: none) | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004513483 A
- JP 2007119343 A
- WO 2009017035 A
- JP 2010167093 A